# EUROPÄISCHE PATENTANMELDUNG

(11) **EP 1 826 811 A1**
(43) Veröffentlichungstag der Anmeldung: **29.08.2007**
(21) Anmeldenummer: 06110305.7
(22) Anmeldetag: 22.02.2006
(51) Int. Cl.: H01J 37/34, C23C 14/34, C23C 14/35

(54) **Sputtern mit gekühltem Target**

(71) Anmelder: Applied Materials GmbH & Co. KG, 63755 Alzenau (DE)
(72) Erfinder: Krempel-Hesse, Jörg, Dr., 63683, Eckartsborn (DE); Hellmich, Anke, Dr., 63796, Kahl (DE); Orgeich, Gerd, 63759, Freigericht (DE); Hegemann, Thomas, 63759, Freigericht (DE)
(74) Vertreter: Lang, Christian

(57) **Zusammenfassung**

Die vorliegende Erfindung betrifft eine Vorrichtung und ein Verfahren zum Beschichten von Substraten mittels Zerstäuben (Sputtern) eines Beschichtungsstoffes in Form eines Targets (2), wobei das Target während der Zerstäubung mittels eines am Target oder in der Nähe des Targets vorbei oder durch das Target hindurch geleiteten Kühlmediums gekühlt wird, und wobei das Kühlmedium eine Vorlauftemperatur von weniger als 20°C aufweist.

## Beschreibung

### Technisches Gebiet

Die vorliegende Erfindung betrifft ein Verfahren nach dem Oberbegriff des Anspruchs 1, sowie eine Vorrichtung nach dem Oberbegriff des Anspruchs 8.

### Stand der Technik

Zerstäubungsverfahren (Sputterverfahren) zum Beschichten von Substraten, bei welchen in einer Vakuumkammer durch ein Plasma Ionen erzeugt werden, die in Richtung einer Kathode beschleunigt werden und dort auf ein zu zerstäubendes Material, nämlich den Beschichtungswerkstoff, in Form eines Targets auftreffen, sind allgemein bekannt. Ebenfalls ist hierbei bekannt, so genannte Magnetrons einzusetzen, bei denen durch Ausbildung eines Magnetfeldes im Bereich des Targets eine verbesserte Zerstäubung und damit höhere Beschichtungsraten ermöglicht werden. Insbesondere sind auch bewegliche Magnetanordnungen bekannt, die zu einer verbesserten Ausnutzung des Targets und somit des Beschichtungswerkstoffes dienen. Eine entsprechende Vorrichtung hierfür ist beispielsweise in der EP 063 45 00 B1 beschrieben.

Um die durch das Auftreffen der Ionen auf das Target erzeugte Wärme abzuführen, ist es aus dem Stand der Technik ebenfalls bekannt, entsprechende Kühleinrichtungen vorzusehen, die durch Durch- oder Vorbeileiten eines Kühlmediums im Bereich des Targets die entstandene Wärme abführen. Auch dies ist beispielsweise in der EP 063 45 00 B1 bzw. der DE 199 16 938 A1 beschrieben.

Üblicherweise wird hierfür als Kühlmedium Wasser eingesetzt, welches bei Raumtemperatur in die Kühlkanäle im Bereich des Targets eingebracht wird.

Obwohl die oben beschriebenen Sputterverfahren und Vorrichtungen hierfür überwiegend zufriedenstellende Ergebnisse liefern, wurde festgestellt, dass insbesondere bei bestimmten Beschichtungswerkstoffen bzw. Targetmaterialien, wie beispielsweise Indiumzinnoxyd (ITO) oder allgemein bei transparenten leitfähigen Oxyden oder keramischen Targets das Problem der so genannten Verpickelung oder Nodule-Bildung an der Targetoberfläche auftritt. Die Pickel oder Nodules, die sich an der Targetoberfläche bilden, sind aus einem extrem harten Stoff gebildet, der den weiteren Sputterprozess negativ beeinflusst und insbesondere bei unterhalb des Targets liegenden Substraten durch späteres Ablösen von der Targetoberfläche zu Beeinträchtigungen der Schichtqualität führen.

Um diesem Problem Herr zu werden, sind im Stand der Technik Verfahren beschrieben, die eine Erhöhung der Targettemperaturen auf Werte von mehr als 100°C (JP 020 509 51 A), mehr als 200°C (DE 100 18 842 C2) oder sogar auf Werte von mehr als 400-500°C (JP 05 34 59 73 A) vorschlagen. Bei derartigen Verfahren wurden somit die Targets nicht mehr gekühlt sondern vielmehr beheizt, um der unerwünschten Nodule-Bildung entgegen zu wirken. Gleichwohl sind damit insgesamt keine zufriedenstellenden Ergebnisse gefunden worden.

### Darstellung der Erfindung Technische Aufgabe

Es ist deshalb Aufgabe der vorliegenden Erfindung ein Verfahren und eine Vorrichtung für Sputterprozesse bereitzustellen, die es ermöglichen, der nachteiligen Nodule-Bildung auf Targets, insbesondere bei keramischen Targets, vorzugsweise Targets zur Abscheidung von leitfähigen transparenten Oxyden und insbesondere Indiumzinnoxyd-Targets in einfacher und effizienter Weise entgegenzuwirken. Technische Lösung

Diese Aufgabe wird gelöst durch ein Verfahren mit den Merkmalen des Anspruchs 1 sowie einer Vorrichtung mit den Merkmalen des Anspruchs 8. Vorteilhafte Ausgestaltungen sind Gegenstand der abhängigen Ansprüche.

Die Erfinder haben überraschend gefunden, dass einer Verpickelung bzw. Nodule-Bildung wirksam begegnet werden kann, wenn die Targettemperatur deutlich abgesenkt wird. Dies kann dadurch erreicht werden, dass zum Kühlen des Targets ein Kühlmedium mit einer Vorlauftemperatur von weniger als 20°C vorgesehen wird. Je niedriger die Targettemperatur bzw. die Vorlauftemperatur des Kühlmediums ist, desto geringer ist die Nodule-Bildung. Ca. 80 - 90% der in die Sputterkathode eingebrachten elektrischen Energie müssen mit dem Kühlmedium abgeführt werden, um das Target ausreichend zu kühlen. Dieser Energieeintrag in das Kühlmedium kann insbesondere bei Magnetronkathoden größerer Länge oder bei hohen Sputterleistungen zu einer starken Aufheizung des Kühlmediums führen, so dass das Target nahe dem Kühlmediumeinlauf noch die gewünschte Temperatur aufweist, sich jedoch mit zunehmender Annäherung an den Kühlmediumauslauf eine Temperaturüberhöhung einstellen kann. Diese Temperaturüberhöhung kann wiederum zur Folge haben, dass auf der Erosionsfläche des Targets im Bereich des Kühlmediumeinlaufs erfindungsgemäß die Entstehung von Nodules unterdrückt wird, in einem mittleren Bereich stetig zunimmt und im Bereich des Kühlmediumauslaufs unverändert stark wie beim bisherigen Stand der Technik auftritt. Um die Nodule-Bildung wirksam auf der ganzen Targetoberfläche zu unterdrücken, sollte vorzugsweise also auch darauf geachtet werden, dass die Erwärmungsstrecken für das Kühlmedium durch geeignete Maßnahmen ausreichend kurz gehalten werden, was beispielsweise damit erreicht werden kann, dass über die Targetlänge mehrere getrennte Kühlkreisläufe vorgesehen werden. Aus diesem Grund ist es auch von Vorteil, nicht nur die Temperatur des Kühlmediumvorlaufs, sondern (auch) die des Kühlmediumrücklaufes der einzelnen Kühlkreisläufe zu überwachen bzw. durch eine Regelung unterhalb einer bestimmten Temperatur zu halten.

Insbesondere hat sich als Vorteil erwiesen, ein Kühlmedium mit einer Vorlauf- und/oder Rücklauftemperatur von weniger als 5°C, also knapp im Bereich des Gefrierpunktes oder darunter bzw. deutlich bei Minusgraden von ca. -20°C oder weniger als -100°C vorzusehen.

Entsprechend kann das Kühlmedium sowohl eine Kühlflüssigkeit oder auch ein Kühlgas sein, wobei insbesondere Wasser, Luft, Kohlenwasserstoffe, insbesondere Flurkohlenwasserstoffe, Alkohole oder dergleichen sowie Gemische davon in Betracht kommen, abhängig davon, welche Vorlauf- bzw. Rücklauftemperatur für das Kühlmedium gewählt wird.

Die Vermeidung bzw. Verringerung der Nodule-Bildung wird hierbei bei sämtlichen Targets bzw. Beschichtungswerkstoffen, die zur Verpickelung bzw. Nodule-Bildung neigen, gewährleistet, insbesondere bei der Abscheidung von Oxydschichten, vorzugsweise transparenten leitfähigen Oxydschichten wie Zinn- oder Zinkoxydschichten, insbesondere Indiumzinnoxydschichten. Kurze Beschreibung der Zeichnungen

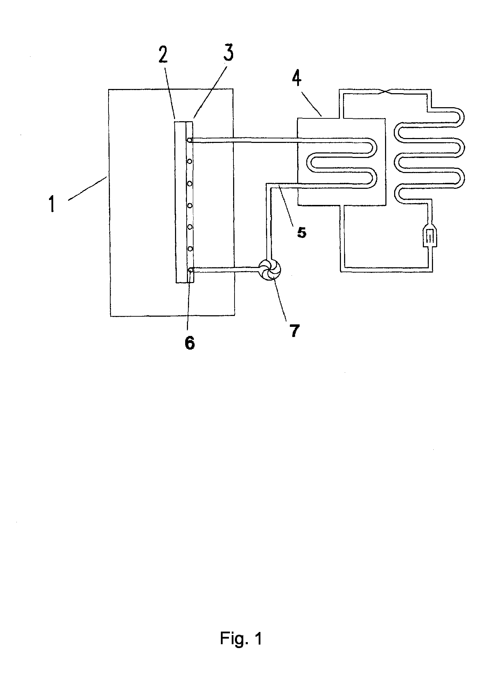

Weitere Vorteile, Kennzeichen und Merkmale der vorliegenden Erfindung werden bei der nachfolgenden Beschreibung eines bevorzugten Ausführungsbeispiels anhand der beigefügten Zeichnung deutlich. Die Figur zeigt in einer schematischen Darstellung die wesentlichen Komponenten einer erfindungsgemäßen Sputtervorrichtung. Bester Weg zur Ausführung der Erfindung

In der beigefügten Figur sind die wesentlichen Komponenten einer erfindungsgemäßen Vorrichtung zur Durchführung des erfindungsgemäßen Verfahrens in einer schematischen Darstellung gezeigt.

Die Figur zeigt eine Vakuumkammer 1 in der das Substrat (nicht gezeigt) durch Zerstäuben eines Targets 2 mittels von im Plasma erzeugten Ionen beschichtet wird. Das Target 2 ist auf einer so genannten Targetrückplatte 3 (target backing plate) angeordnet, welche von Kühlkanälen 6 durchzogen ist. Die Kühlkanäle 6 sind mit einer Leitung 5 verbunden, in der eine Pumpe 7 angeordnet ist, so dass in dem geschlossenen Kreislauf der Leitung 5 ein Kühlmittel im Kreis gepumpt werden kann, welches die Kühlkanäle 6 der Targetrückplatte 3 durchströmt und damit die beim Beschuss des Targets 2 durch die Ionen erzeugte Wärme abführt.

Die Leitung 5 ist mit Leitungsschlaufen in einem Wärmetauscher eines Kühlaggregates 4 geführt, so dass das Kühlmedium auf eine bestimmte Vorlauftemperatur gekühlt werden kann, welche das Kühlmedium beim Eintritt in die Kühlkanäle 6 der Targetrückplatte 3 aufweist. Die Rücklauftemperatur des Kühlmediums ist nach dem Durchlaufen der Kühlkanäle 6 in der Targetrückplatte 3 durch die Aufnahme der Wärme vom Target 2 erhöht und wird in dem Wärmetauscher des Kühlaggregates 4 wieder auf die gewünschte Vorlauftemperatur reduziert.

Die Kühlmittelleitung 5 ist insbesondere im Bereich zwischen dem Wärmetauscher des Kälteaggregates 4 und den Kühlkanälen 6 der Targetrückplatte 3 isoliert ausgeführt, um eine vorzeitige Erwärmung des Kühlmediums auszuschließen und Kondenswasser zu vermeiden.

Bei dem bevorzugten Ausführungsbeispiel wurde ein Indiumzinnoxyd(ITO)-Target 2 in einer Argon/Sauerstoffatmosphäre bei einem Druck von ca. 5 x 10⁻³ mbar und einer Leistung von 19 KW zerstäubt und auf dem Substrat abgeschieden, wobei die Vorlauftemperatur, also die Einlauftemperatur des Kühlmediums in die Kühlkanäle 6 der Targetrückplatte 3 bei 5°C lag und die Rücklauftemperatur 11°C betrug. Der Durchfluss des Kühlmediums lag bei ca. 181 pro Minute, wobei als Kühlmedium Wasser verwendet worden ist.

Das Target 2 wurde an einer nicht näher dargestellten planaren Magnetronkathode mit einer beweglichen Magnetanordnung eingesetzt.

Im Vergleich zu einem Sputterversuch mit einer Kühlmediumvorlauftemperatur von 21 ° C wurde auf dem Target eine deutlich verringerte Anzahl von so genannten Nodules oder Pickeln festgestellt.

Obwohl bei dem beschriebenen Ausführungsbeispiel Wasser als Kühlmedium verwendet worden ist, können auch andere Kühlmedien, wie insbesondere Flüssigkeiten, die bei Minustemperaturen flüssig bleiben, als auch Kühlgase verwendet werden. Insbesondere wurde festgestellt, dass eine zunehmende Absenkung der Targettemperatur bzw. der Vorlauftemperatur zu einer weiteren Verminderung der Anzahl von Nodules oder Pickeln führt, so dass insbesondere Temperaturen unter 0°C vorzugsweise -20°C bzw. -100°C als besonders interessant erscheinen. Insbesondere sind kommerzielle Kühlgeräte bis in den Temperaturbereich von -120°C verfügbar.

Obwohl bei dem beschriebenen Ausführungsbeispiel ein Indiumzinnoxyd-Target in einer Argonatmosphäre mit geringen Anteilen Sauerstoff verwendet worden ist, können unterschiedlichste Targetmaterialien, wie reine Metalle oder sonstige Verbindungen, wie Oxyde, auch in reinen Inertatmosphären oder unter Zugabe von Reaktivstoffen (reaktives Sputtern) eingesetzt werden.

Obwohl bei der bevorzugten Ausführungsform das Target auf einer Targetrückplatte (target backing plate) vorgesehen ist, sind insbesondere auch Targets ohne Rückplatte 3 denkbar, wobei die Kühlkanäle 6 unmittelbar am Target 2 vorgesehen sein können, wie dies teilweise beim Eingangs zitierten Stand der Technik der Fall ist.

## Patentansprüche

1. Verfahren zum Beschichten von Substraten mittels Zerstäuben (Sputtern) eines Beschichtungsstoffes in Form eines Targets (2), wobei das Target während der Zerstäubung mittels eines am Target oder in der Nähe des Targets vorbei oder durch das Target hindurch geleiteten Kühlmediums gekühlt wird,
**dadurch gekennzeichnet, dass** das Kühlmedium eine Vorlauf- und/oder Rücklauftemperatur von weniger als 20°C aufweist.

2. Verfahren nach Anspruch 1,
**dadurch gekennzeichnet, dass** das Kühlmedium eine Vorlauf- und/oder Rücklauftemperatur von weniger als 5°C, vorzugsweise weniger als 0°C, höchst vorzugsweise weniger als -20°C, insbesondere weniger als -100°C aufweist.

3. Verfahren nach Anspruch 1 oder 2,
**dadurch gekennzeichnet, dass** als Kühlmedium Kühlflüssigkeit oder Kühlgase verwendet werden, insbesondere Wasser, Luft, Kohlenwasserstoffe, insbesondere Flurkohlenwasserstoffe, Alkohole oder dergleichen oder Gemische davon.

4. Verfahren nach einem der vorhergehenden Ansprüche,
**dadurch gekennzeichnet, dass** das Verfahren im Hochvakuum und/oder unter Verwendung von Magnetron-Sputterquellen, insbesondere planaren und/oder mit beweglichen Magnetanordnung versehenen Magnetronsputterquellen durchgeführt wird.

5. Verfahren nach einem der vorhergehenden Ansprüche,
**dadurch gekennzeichnet, dass** reaktives Zerstäuben unter Verwendung eines Reaktivstoffes, insbesondere Reaktivgases für das zerstäubte Beschichtungsmaterial durchgeführt wird.

6. Verfahren nach einem der vorhergehenden Ansprüche,
**dadurch gekennzeichnet, dass** Oxidschichten, insbesondere transparente leitfähige Oxidschichten, vorzugsweise Zinn- und/oder Zinkoxid-Schichten, höchst vorzugsweise Indium-Zinn-Oxid-Schichten (ITO) abgeschieden werden.

7. Verfahren nach einem der vorhergehenden Ansprüche,
**dadurch gekennzeichnet, dass** Oxid-Targets, insbesondere Targets aus transparenten leitfähigen Oxidschichten, vorzugsweise Zinn- und/oder Zinkoxid-Targets, höchst vorzugsweise Indium-Zinn-Oxid-Targets (ITO) eingesetzt werden.

8. Vorrichtung zum Beschichten von Substraten mittels Zerstäuben (Sputtern) eines Beschichtungsstoffes in Form eines Targets (2), insbesondere zur Durchführung des Verfahrens nach einem der Ansprüche 1 bis 7, mit einer Kühleinrichtung (4) zur mittelbaren oder unmittelbaren Kühlung des Targets mittels eines Kühlmediums,
**dadurch gekennzeichnet, dass** die Kühleinrichtung ein Kälteaggregat umfasst, welches so hergerichtet ist, dass das Kühlmedium auf eine Vorlauf- und/oder Rücklauftemperatur von weniger als 20°C gekühlt werden kann.

9. Vorrichtung nach Anspruch 8,
**dadurch gekennzeichnet, dass** das Kühlaggregat so hergerichtet ist, dass das Kühlmedium eine Vorlauf- und/oder Rücklauftemperatur von weniger als 5°C, vorzugsweise weniger als 0°C, höchst vorzugsweise weniger als -20°C, insbesondere weniger als -100°C aufweist.

10. Vorrichtung nach Anspruch 8 oder 9,
**dadurch gekennzeichnet, dass** die Kühleinrichtung so hergerichtet ist, dass als Kühlmedium Kühlflüssigkeit oder Kühlgase verwendet werden, insbesondere Wasser, Luft, Kohlenwasserstoffe, insbesondere Flurkohlenwasserstoffe, Alkohole oder dergleichen oder Gemische davon.

11. Vorrichtung nach einem der Ansprüche 8 bis 10,
**dadurch gekennzeichnet, dass**die Kühleinrichtung eine Steuerungs- und/oder Regelungseinheit zur Steuerung und/oder Regelung der Vorlauf- und/oder Rücklauftemperatur aufweist.

12. Vorrichtung nach einem der Ansprüche 8 bis 11,
**dadurch gekennzeichnet, dass**die Kühleinrichtung ein oder mehrere voneinander unabhängige Kühlkreisläufe umfasst.
